# FASCICULE DE BREVET EUROPEEN

(11) **EP 2 809 137 B1**
(45) Date de publication et mention de la délivrance du brevet: **19.02.2020**
(21) Numéro de dépôt: 14169830.8
(22) Date de dépôt: 26.05.2014
(51) Int. Cl.: H05K 7/20

(54) **Système de refroidissement, système informatique refroidi et installation informatique**
Kühlsystem, gekühltes informationsverarbeitendes System und IT-Anlage
Cooling system, cooled computer system and computer facility

(30) Priorité: 30.05.2013 FR 1354943
(43) Date de publication de la demande: 03.12.2014
(73) Titulaire: Bull S.A.S., 78340 Les Clayes-sous-Bois (FR)
(72) Inventeur: Lecourtier, Georges, 78000 Versailles (FR)
(74) Mandataire: Bonnet, Michel

(56) Documents cités:
- US-A1- 2007 297 136
- US-A1- 2009 188 264
- US-A1- 2011 247 348
- US-A1- 2012 120 603

## Description

La présente invention concerne un système de refroidissement, un système informatique refroidi et une installation informatique.

L'invention s'applique plus particulièrement dans les centres de données (« data centers » en anglais) qui regroupent énormément de puissance de calcul sur une surface réduite.

Il est connu d'utiliser un système de refroidissement de composants électroniques d'une armoire informatique, du type comportant :
- un circuit fermé, appelé circuit primaire, de liquide, appelé liquide primaire,
- un échangeur primaire destiné à transférer de la chaleur depuis des premiers composants électroniques vers le liquide primaire, l'échangeur primaire comportant une pièce conductrice de chaleur au contact du liquide primaire et destinée à être plaquée contre ces premiers composants électroniques,
- un circuit fermé, appelé circuit secondaire, de fluide réfrigérant,
- un échangeur primaire-secondaire destiné à transférer de la chaleur depuis le liquide primaire vers le fluide réfrigérant,
- un circuit fermé, appelé circuit tertiaire, de liquide, appelé liquide tertiaire,
- un échangeur secondaire-tertiaire destiné à transférer de la chaleur depuis le fluide réfrigérant vers le liquide tertiaire, de sorte que le fluide réfrigérant change au moins en partie d'état, et
- un échangeur tertiaire-source thermique destiné à transférer de la chaleur depuis le liquide tertiaire vers une source thermique.

Un tel système est par exemple divulgué dans le document de brevet US 2012/0120603 A1. Ce système de refroidissement connu emploie la méthode de refroidissement direct liquide (de l'anglais « Direct Liquid Cooling » ou DLC), particulièrement efficace pour les composants électroniques plats et dégageant beaucoup de chaleur par unité de surface (qualifiés de fortement dissipatifs), tels que les processeurs ou les mémoires.

Cependant, cette méthode présente comme inconvénient de ne pas pouvoir être utilisée pour les composants électriques n'ayant pas une forme plate. En outre, cette méthode est relativement coûteuse pour les composants électroniques moyennement dissipatifs.

Il peut ainsi être souhaité de prévoir un système de refroidissement qui permette de s'affranchir d'au moins une partie des problèmes et contraintes précités.

Il est donc proposé un système de refroidissement du type précité, caractérisé en ce qu'il comporte en outre :
- un échangeur tertiaire-secondaire destiné à transférer de la chaleur depuis le liquide tertiaire vers le fluide réfrigérant, et
- un échangeur air-tertiaire destiné à transférer, vers le liquide tertiaire, de la chaleur depuis de l'air de l'armoire informatique chauffé par des seconds composants électroniques, l'échangeur air-tertiaire étant disposé, dans le circuit tertiaire, en aval de l'échangeur tertiaire-secondaire et en amont de l'échangeur secondaire-tertiaire.

Ainsi, grâce à un système selon l'invention, il est possible de refroidir de façon efficace des composants électroniques de types variés, notamment des composants peu dissipatifs ou de forme non plate en plus des composants dissipatifs et plats tels que les processeurs et les mémoires.

De façon optionnelle, le circuit secondaire comporte des première et seconde boucles passant toutes les deux dans l'échangeur secondaire-tertiaire et présentant une portion commune, dans lequel la première boucle contourne l'échangeur tertiaire-secondaire et la seconde boucle contourne l'échangeur primaire-secondaire, l'échangeur primaire-secondaire est disposé dans la première boucle et l'échangeur tertiaire-secondaire est disposé dans la seconde boucle.

De façon optionnelle également, le circuit secondaire comporte un régulateur de débit du fluide réfrigérant circulant dans les première et seconde boucles, disposé dans la portion commune aux première et seconde boucles.

De façon optionnelle également, le régulateur de débit est destiné à favoriser le débit dans la première boucle par rapport au débit dans la seconde boucle pour réguler la température des premiers composants électroniques.

De façon optionnelle également, le circuit tertiaire comporte des première et seconde boucles passant toutes les deux dans l'échangeur secondaire-tertiaire, la première boucle contourne l'échangeur tertiaire-secondaire et l'échangeur air-tertiaire, et l'échangeur tertiaire-secondaire et l'échangeur air-tertiaire sont disposés dans la seconde boucle.

De façon optionnelle également, le système de refroidissement comporte en outre un échangeur primaire-tertiaire destiné à transférer de la chaleur depuis le liquide primaire vers le liquide tertiaire.

De façon optionnelle également, le circuit tertiaire comporte une troisième boucle contournant l'échangeur tertiaire-secondaire et l'échangeur secondaire tertiaire, et passant dans l'échangeur tertiaire-source thermique, et l'échangeur primaire-tertiaire est disposé dans la troisième boucle.

De façon optionnelle également, le système de refroidissement comporte en outre un régulateur de pression destiné à réguler la pression du fluide réfrigérant en fonction de la température du liquide tertiaire.

Il est également proposé un système informatique refroidi comportant : une armoire informatique renfermant des composants électroniques ; et un système de refroidissement des composants électroniques de l'armoire informatique tel que défini précédemment ; et dans lequel l'échangeur air-tertiaire est disposé dans une face arrière de l'armoire informatique par laquelle de l'air est destiné à sortir de l'armoire informatique.

De façon optionnelle, l'armoire informatique comporte un système de ventilation pour favoriser la sortie de l'air par la face arrière, au travers de l'échangeur air-tertiaire.

Il est également proposé une installation informatique comportant : un système informatique refroidi tel que défini précédemment ; une salle informatique dans laquelle l'armoire informatique est disposée ; et une armoire de servitude disposée dans la salle informatique et renfermant au moins une partie des éléments du système de refroidissement.

L'invention sera mieux comprise à l'aide de la description qui va suivre, donnée uniquement à titre d'exemple et faite en se référant aux dessins annexés dans lesquels :
- la figure 1 représente schématiquement la structure générale d'une installation informatique, selon un premier mode de réalisation de l'invention,
- la figure 2 représente schématiquement la structure générale d'une installation informatique, selon un second mode de réalisation de l'invention, et
- la figure 3 représente schématiquement la structure générale d'une installation informatique, selon un troisième mode de réalisation de l'invention.

Sur les figures, les flèches épaisses représentent les transferts de chaleur. En outre, les composants de régulation et les clapets anti-retour ne sont pas représentés.

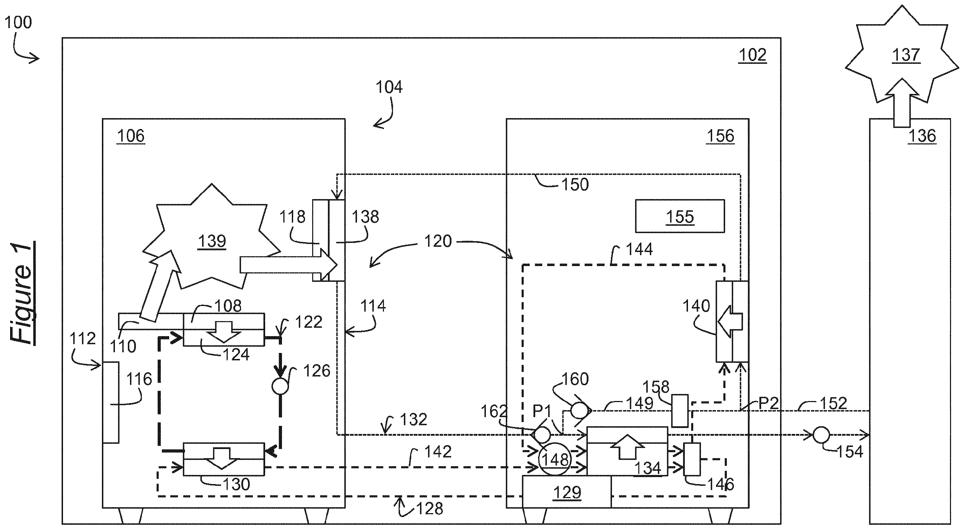

En référence à la figure 1, une installation informatique 100 selon un premier mode de réalisation de l'invention va à présent être décrite.

L'installation informatique 100 comporte tout d'abord une salle informatique 102.

L'installation informatique 100 comporte en outre un système informatique refroidi 104.

Le système informatique refroidi 104 comporte tout d'abord une armoire informatique 106 disposée dans la salle informatique 102, et renfermant des composants électroniques 108, 110. Les composants électroniques 108, 110 regroupent deux types de composants électroniques.

Les composants électroniques 108 du premier type génèrent beaucoup de chaleur par unité de surface, par exemple entre 50 et 100 W/cm². Ils sont qualifiés de « très dissipatifs ». Ce sont généralement des composants électroniques fortement intégrés et/ou à interfaces très rapides. Les composants électroniques 108 sont par exemple des microprocesseurs à hautes performances. Les composants électroniques 108 sont en outre généralement plats.

Les composants électroniques 110 du second type génèrent moins de chaleur par unité de surface, par exemple entre 0,5 et 1 W/cm². Ils sont qualifiés de « peu ou moyennement dissipatifs ». Les composants électroniques 110 sont en outre généralement de formes variées non planes. Les composants électroniques 110 sont par exemple des barrettes mémoire en double ligne, de l'anglais *« dual in-line memory module* » signifiant module de mémoire en ligne dual, des convertisseurs d'alimentation à découpage, ou des alimentations linéaires.

L'armoire informatique 106 présente une face avant 112 par laquelle de l'air est destiné à entrer et une face arrière 114 par laquelle l'air est destiné à sortir. L'armoire informatique 106 renferme en outre un système de ventilation avant 116 destiné à favoriser l'entrée d'air par la face avant 112 et un système de ventilation arrière 118 destiné à favoriser la sortie d'air par la face arrière 114, de sorte que les systèmes de ventilation 116, 118 engendrent un flux d'air à la pression normale, c'est-à-dire 1 atm à 20 °C.

Le système informatique refroidi 104 comporte en outre un système 120 de refroidissement des composants électroniques 108, 110.

Le système de refroidissement 120 comporte tout d'abord un premier circuit fermé 122 de liquide. Le circuit 122 sera appelé par la suite circuit primaire 122, et le liquide sera appelé par la suite liquide primaire. Le liquide primaire est par exemple de l'eau ou un mélange eau-antigel. Le liquide primaire reste à l'état liquide tout le long du circuit primaire 122. Le circuit primaire 122 présente une boucle, unique dans l'exemple décrit, dans laquelle un échangeur primaire 124 est disposé afin de transférer de la chaleur depuis les composants électroniques 108 vers le liquide primaire. A cet effet, l'échangeur primaire 124 est de préférence un échangeur de type plaque froide comportant au moins un bloc, par exemple en aluminium, à l'intérieur duquel circule le liquide primaire, le bloc étant plaqué directement contre les composants électroniques 108. Le plaquage est d'autant plus efficace que les composants électroniques 108 sont plats.

Le circuit primaire 122 comporte en outre une pompe 126 disposée dans la boucle et destinée à faire circuler le liquide primaire dans le circuit primaire 122. La pompe 126 se situe en aval de l'échangeur primaire 124, et peut être, au choix, à vitesse constante ou variable.

Le système de refroidissement 120 comporte en outre un second circuit fermé 128 de fluide. Le circuit 128 sera appelé par la suite circuit secondaire 128. Le fluide est un fluide réfrigérant destiné, comme cela sera expliqué par la suite, à changer d'état lors de sa circulation dans le circuit secondaire 128. Le fluide réfrigérant est par exemple du dioxyde de carbone (nomenclature industrielle R744). Dans l'exemple décrit, le fluide réfrigérant circule dans le circuit secondaire 128 sous une pression variant autour d'une pression moyenne, par exemple de l'ordre de 65 atm suivant sa position le long du circuit secondaire 128. De préférence, le circuit secondaire 128 comporte un régulateur de pression 129 destiné à réguler la pression moyenne du fluide réfrigérant, par exemple entre 50 et 70 atm.

Le système de refroidissement 120 comporte en outre un échangeur primaire-secondaire 130 destiné à transférer de la chaleur depuis le liquide primaire vers le fluide réfrigérant. Le fluide réfrigérant entre dans l'échangeur primaire-secondaire 130 sous forme liquide, où il subit une baisse de pression et un passage, au moins partiel, sous forme gazeuse. Le changement d'état du liquide en gaz permet l'absorption qu'une quantité importante de chaleur, appelée chaleur latente d'évaporation.

Le système de refroidissement 120 comporte en outre un troisième circuit fermé 132 de liquide. Le circuit 132 sera appelé par la suite circuit tertiaire 132, et le liquide sera appelé par la suite liquide tertiaire. Le liquide tertiaire est par exemple de l'eau. Le liquide tertiaire reste à l'état de liquide tout le long du circuit tertiaire 132.

Le système de refroidissement 120 comporte en outre un échangeur secondaire-tertiaire 134 destiné à transférer de la chaleur depuis le fluide réfrigérant vers le liquide tertiaire. Lors de ce transfert de chaleur, le fluide réfrigérant change, au moins en partie, d'état. Par exemple, l'échangeur secondaire-tertiaire 134 est un condenseur dans lequel le fluide réfrigérant entre sous forme gazeuse (à sa sortie d'un compresseur 148 qui sera décrit plus en détails plus loin) et dans lequel la température du fluide réfrigérant est abaissée de sorte qu'au moins une partie du fluide réfrigérant passe sous forme liquide. L'échangeur secondaire-tertiaire 134 fait en outre fonction de séparateur de phase liquide/gazeuse du fluide réfrigérant, afin d'éviter que du fluide réfrigérant sous forme gazeuse ne soit réintroduit dans le circuit secondaire 128.

Le système de refroidissement 120 comporte en outre un échangeur tertiaire-source thermique 136 destiné à transférer de la chaleur depuis le liquide tertiaire vers une source thermique 137 de capacité quasi-infinie, comme l'atmosphère, un fleuve ou un lac. Par exemple l'échangeur tertiaire-source thermique 136 est un aéroréfrigérant destiné à transférer de la chaleur depuis le liquide tertiaire vers l'atmosphère. L'aéroréfrigérant force l'air extérieur à travers des surfaces d'échange pour ramener la température du liquide tertiaire à une valeur proche de la température de la source thermique 137, c'est-à-dire dans ce cas de la température ambiante extérieure. L'échangeur tertiaire-source thermique 136 est de préférence situé à l'extérieur de la salle informatique 102. Le liquide tertiaire entre dans l'échangeur tertiaire-source thermique 136 avec une température généralement 20°C plus élevée que sa température en sortie de l'échangeur tertiaire source thermique 136.

Ainsi, la chaleur est évacuée des composants électroniques 108 jusqu'à la source thermique 137 par le premier chemin d'évacuation de chaleur suivant: échangeur primaire 124, circuit primaire 122, échangeur primaire-secondaire 130, circuit secondaire 128, échangeur secondaire-tertiaire 134, circuit tertiaire 132 (dans l'exemple décrit, une boucle 149 de ce circuit tertiaire 132, qui sera décrite plus en détails plus loin) et échangeur tertiaire-source thermique 136.

Pour évacuer la chaleur des composants électroniques 110, le système de refroidissement 120 définit en outre un deuxième chemin d'évacuation de chaleur, qui va à présent être décrit.

Le système de refroidissement 120 comporte un échangeur air-tertiaire 138 destiné à transférer, vers le liquide tertiaire, de la chaleur depuis l'air 139 de l'armoire informatique 106, cet air 139 ayant été chauffé par les composants électroniques 110 et, dans une moindre mesure, par les composants électroniques 108. Pour favoriser le transfert de chaleur, le système de ventilation arrière 118 dirige l'air 139 vers l'échangeur air-tertiaire 138. Ainsi, la chaleur de l'air 139 de l'armoire informatique 106 n'est pas évacuée dans la salle informatique 102, ce qui permet d'utiliser des climatiseurs de dimensions réduites, et donc moins chers, pour climatiser la salle informatique 102.

Ainsi, la chaleur est évacuée des composants électroniques 110 jusqu'à la source thermique 137 par le second chemin d'évacuation de chaleur suivant : air 139 de l'armoire informatique 106, échangeur air-tertiaire 138, circuit tertiaire 132 et échangeur tertiaire-source thermique 136.

Comme indiqué précédemment, le liquide tertiaire sort de l'échangeur tertiaire-source thermique 136 à une température proche de celle de la source thermique 137. Or, cette température est généralement relativement élevée, par exemple autour de 20°C lorsque la source thermique 137 est l'atmosphère. Pour améliorer l'efficacité de l'échangeur air-tertiaire 138, il est donc préférable d'abaisser la température du liquide tertiaire avant son entrée dans l'échangeur air-tertiaire 138. À cet effet, le système de refroidissement 120 comporte en outre un échangeur tertiaire-secondaire 140 placé dans le circuit tertiaire 132 en amont de l'échangeur air-tertiaire 138 et en aval de l'échangeur secondaire-tertiaire 134. L'échangeur tertiaire-secondaire 140 est destiné à transférer de la chaleur depuis le liquide tertiaire vers le fluide réfrigérant. Ce dernier entre ainsi dans l'échangeur tertiaire-secondaire 140 sous forme liquide, où il subit une baisse de pression et un passage, au moins partiel sous forme gazeuse. Le changement d'état du liquide en gaz permet l'absorption qu'une quantité importante de chaleur, appelée chaleur latente d'évaporation. Ainsi, le liquide tertiaire arrive refroidi dans l'échangeur air-tertiaire 138, ce qui favorise le transfert de chaleur depuis l'air 139 de l'armoire informatique 106 vers le liquide tertiaire.

Afin que les deux chemins d'évacuation de la chaleur des composants électroniques 108, 110 ne se perturbent pas l'un l'autre, les circuits secondaire 128 et tertiaire 132 présentent des boucles dédiées à chacun de ces chemins, avec certains éléments fusionnés afin de réduire le coût et l'encombrement du système de refroidissement 120. Ces boucles vont à présent être décrites.

Le circuit secondaire 128 comporte des première et seconde boucles 142, 144 présentant une portion commune par laquelle les première et seconde boucles 142, 144 communiquent. Dans l'exemple décrit, le circuit secondaire 128 comporte un régulateur de débit 146 formant cette portion commune et destiné à réguler le débit relatif dans chacune des deux boucles 142, 144. Il est ainsi possible de favoriser l'un ou l'autre des chemins d'évacuation de chaleur. La régulation thermique des composants 108 est généralement prioritaire sur celle des composants électroniques 110, ce qui amène donc à favoriser le premier chemin d'évacuation de chaleur. Ainsi, le régulateur de débit 146 est de préférence configuré pour réguler la température du liquide primaire à une consigne prédéterminée, en augmentant le débit dans la première boucle 142 au détriment du débit dans la seconde boucle 144.

Le circuit secondaire 128 comporte en outre un compresseur 148 destiné à mettre le fluide réfrigérant en circulation dans le circuit secondaire 128 et à ramener le fluide réfrigérant à une pression nominale pour l'échangeur secondaire-tertiaire 134. Le fluide réfrigérant entre dans le compresseur 148 sous forme gazeuse et sort sous forme liquide/gazeuse du compresseur 148. Le compresseur 148, associé à un accumulateur de pression (non représenté), permet aussi de compenser les pertes de pression dues à des micro-fuites dans le circuit secondaire 128 et/ou fluctuations de pression dues à un refroidissement ou un réchauffement du circuit secondaire 128 en fonction de la température de la salle informatique 102. Le compresseur 148 est situé en amont de l'échangeur secondaire-tertiaire 134. Le compresseur 148 est par exemple un turbocompresseur à double corps.

Les première et seconde boucles 142, 144 passent dans le compresseur 148, ainsi que dans l'échangeur secondaire-tertiaire 134 afin que le fluide réfrigérant qui y circule perde de la chaleur au profit du liquide tertiaire.

La première boucle 142 contourne l'échangeur tertiaire-secondaire 140 et comporte l'échangeur primaire-secondaire 130, tandis que la seconde boucle 144 contourne l'échangeur primaire-secondaire 130 et comporte l'échangeur tertiaire-secondaire 140.

Par ailleurs, le circuit tertiaire 132 comporte des première et seconde boucles 149, 150 passant toutes les deux dans l'échangeur secondaire-tertiaire 134 et présentant une portion commune 152 (du point P1 au point P2 en passant par l'échangeur tertiaire-source thermique 136). La portion commune 152 comporte l'échangeur secondaire-tertiaire 134, une pompe 154 et l'échangeur tertiaire-source thermique 136. La pompe 154 est destinée à mettre le liquide tertiaire en circulation dans le circuit tertiaire 132 vers l'échangeur tertiaire-source thermique 136. La première boucle 149 contourne l'échangeur tertiaire-secondaire 140 et l'échangeur air-tertiaire 138 pour relier directement l'échangeur tertiaire-source thermique 136 à l'échangeur secondaire-tertiaire 134. Ainsi, la première boucle 149 appartient au premier chemin d'évacuation de chaleur des composants électroniques 108.

La seconde boucle 150 comporte l'échangeur tertiaire-secondaire 140 et l'échangeur air-tertiaire 138. Ainsi, la seconde boucle 150 appartient au deuxième chemin d'évacuation de chaleur des composants électroniques 110.

Le système de refroidissement 120 comporte en option des vannes de court-circuit (non représentées) disposées en parallèle de respectivement l'échangeur primaire-secondaire 130, l'échangeur air-tertiaire 138 et l'échangeur tertiaire-secondaire 140, afin de réguler les transferts de chaleur réalisés par ces échangeurs.

Le système de refroidissement 120 comporte en outre des moyens de pilotage 155 destinés à piloter la vitesse du compresseur 148, et des pompes 126, 154, en fonction de la température des composants électroniques 108, 110, afin de garder cette température dans les limites acceptables pour les composants électroniques 108, 110.

Le système informatique refroidi 104 comporte en outre une armoire de servitude 156 disposée dans la salle informatique 102 et renfermant le compresseur 148, l'échangeur secondaire-tertiaire 134, le régulateur de débit 146 et l'échangeur tertiaire-secondaire 140. L'utilisation de l'armoire de servitude 156 permet d'isoler acoustiquement les éléments du système de refroidissement 120 et en particulier le compresseur 148. Cet isolement acoustique peut encore être amélioré en capotant le compresseur 148. L'utilisation de l'armoire de servitude 156 permet de diminuer les distances entre composants électroniques, puisque les éléments regroupés dans l'armoire de servitude ne prennent plus de place dans l'armoire informatique 106.

Il peut y avoir plusieurs armoires informatiques 106 pour une seule armoire de servitude 156.

De préférence, des vannes commandées et des clapets antiretours sont utilisés dans les circuits de l'installation informatique 100.

Par exemple, dans l'exemple de la figure 1, une électrovanne 158 est disposée dans la première boucle 149 du circuit tertiaire 132, entre le point P2 et le point P1. En outre, un clapet antiretour 160 est disposé dans la première boucle 149 du circuit tertiaire 132, pour empêcher le fluide tertiaire de circuler depuis le point P1 vers le point P2. En outre, un clapet antiretour 162 est disposé dans la boucle 150 du circuit tertiaire 132, pour empêcher le fluide tertiaire de circuler depuis le point P1 vers l'échangeur air-tertiaire 138.

L'installation informatique 100 décrite précédemment permet par exemple d'évacuer une puissance de l'ordre de 150 kW pour une armoire informatique 106 de dimensions 60 cm x 90 cm x 200 cm, habituellement employée dans les salles informatiques. Une salle informatique comportant 150 armoires informatiques refroidies par des systèmes de refroidissement comme le système de refroidissement 120 est ainsi en mesure d'évacuer en permanence une puissance de plus de 20 MW. Il est ainsi possible de loger davantage de puissance de calcul dans la surface limitée des salles informatiques climatisées.

De préférence, la pression instantanée du fluide réfrigérant varie peu, par exemple de plus ou moins 0,5 atm autour de la pression moyenne (65 atm dans l'exemple décrit précédemment), afin de minimiser les pertes dues au turbocompresseur 148. La pression moyenne dépend de la température du fluide tertiaire. Par exemple, pour une température de fluide tertiaire de 25°C, la pression moyenne optimale (pour le fonctionnement du turbocompresseur) du fluide réfrigérant est de 65 atm. De préférence, le régulateur de pression 129 régule la pression moyenne en fonction de la température de fluide tertiaire. Ainsi, quand la température de fonctionnement du fluide tertiaire doit suivre les contraintes d'évolution de la température extérieure, le régulateur de pression 129 fait évoluer la pression moyenne du circuit secondaire pour minimiser la consommation d'électricité, par exemple entre 50 et 70 atm.

Si une fraction de liquide subsiste en sortie d'un évaporateur 130, 140, elle est piégée par gravité dans un réservoir de liquide, appelé séparateur, qui peut faire partie ou non de l'évaporateur.

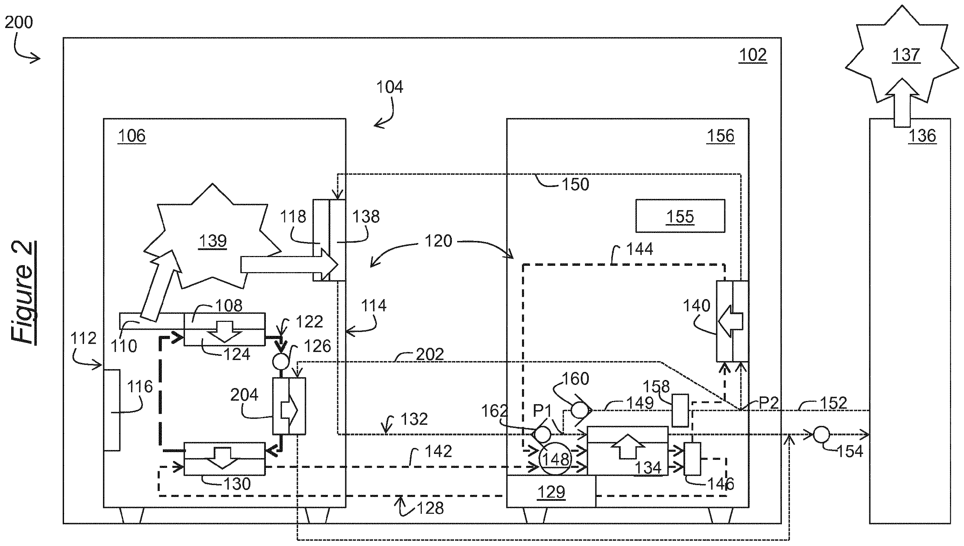

En référence à la figure 2, une installation informatique 200 selon un second mode de réalisation de l'invention va à présent être décrite.

L'installation informatique 200 est identique à celle de la figure 1, si ce n'est que le circuit tertiaire 132 comporte une troisième boucle 202 rejoignant la portion commune 152 des première et seconde boucles 149, 150 en amont de la pompe 154 et quittant cette portion commune 152 en aval de l'échangeur tertiaire-source thermique 136. De ce fait, la troisième boucle 202 passe par la pompe 154 et l'échangeur tertiaire-source thermique 136, et contourne l'échangeur air-tertiaire 138, l'échangeur tertiaire-secondaire 140 et l'échangeur secondaire-tertiaire 134. De préférence, la boucle 202 passe par un faux-plancher de la salle 102. La raison est due au diamètre relativement important (4 à 6 cm) des tuyaux de la boucle 202.

En outre, le système de refroidissement 120 comporte, disposé dans la troisième boucle 202, un échangeur primaire-tertiaire 204 destiné à transférer de la chaleur depuis le liquide primaire vers le liquide tertiaire. L'échangeur primaire-tertiaire 204 est par exemple un échangeur à plaques.

Ainsi, la chaleur est évacuée des composants électroniques 108 jusqu'à la source thermique 137 par le troisième chemin d'évacuation de chaleur suivant: échangeur primaire 124, circuit primaire 122, échangeur primaire-tertiaire 204, circuit tertiaire 132 et échangeur tertiaire-source thermique 136.

La présence d'un transfert de chaleur depuis le liquide primaire vers le liquide tertiaire permet un dimensionnement plus petit des éléments des premier et second chemins d'évacuation de chaleur puisque moins de chaleur est évacuée par ces deux chemins. En particulier, la consommation électrique du compresseur 148 est diminuée.

L'efficacité énergétique du système de refroidissement 120 repose en particulier sur une régulation de la pression du fluide secondaire en sortie du régulateur de débit 146, telle que le compresseur 148 n'ait à fournir qu'un minimum d'énergie pour permettre le changement d'état du fluide réfrigérant, tout en assurant un débit important dans le circuit secondaire 128. Ce débit est en effet responsable des quantités de chaleur qui peuvent être extraites du circuit primaire 122.

Par ailleurs, l'écart de température entre la température du fluide secondaire en sortie de l'échangeur primaire-secondaire 130 et la température du liquide tertiaire en entrée de l'échangeur secondaire-tertiaire 134 est régulé autour d'une valeur la plus faible possible afin de maximiser l'efficacité énergétique définie par la puissance de transfert de chaleur dans l'échangeur secondaire-tertiaire 134 par rapport à la puissance fournie au compresseur 148.

Par ailleurs, la valeur exacte de la pression du fluide réfrigérant dépend en particulier de la température du liquide tertiaire, mais est maintenue par une régulation appropriée à une valeur où le compresseur 148 consomme le moins d'électricité possible.

La température du liquide tertiaire en entrée de l'échangeur air-tertiaire 138 est régulée de façon telle que la puissance rayonnée et/ou dissipée par convection naturelle à évacuer dans l'air de la salle informatique 102 (par exemple de l'ordre de 5 kW) soit compensée par l'absorption de puissance dans l'échangeur air-tertiaire 138. On notera que, pendant l'hiver, lorsque les températures de retour de liquide tertiaire sont très basses (car la température de la source thermique 137 est très basse), l'air 139 peut servir de chauffage pour la salle informatique 102 en court-circuitant plus ou moins l'échangeur air-tertiaire 138.

En option, sur la figure 2, le circuit 132 peut être rendu indépendant du circuit 152 et constituer une quatrième boucle de refroidissement si on y insère une pompe de circulation. Ce circuit peut alors transporter un liquide différent de celui de la boucle 152, par exemple un liquide diélectrique permettant de limiter les risques électriques en cas de fuite. Cette boucle peut alors être utilisée en mode de refroidissement liquide direct (de l'anglais « Direct Liquid Cooling »), comme le circuit 122, mais au contact de composants présentant un danger potentiel (hautes tensions, ...). En option, dans ce dernier cas, il est possible de supprimer le circuit 144 et d'évacuer la chaleur introduite en 138 vers le liquide tertiaire via un échangeur 204 à triple circuit hydraulique.

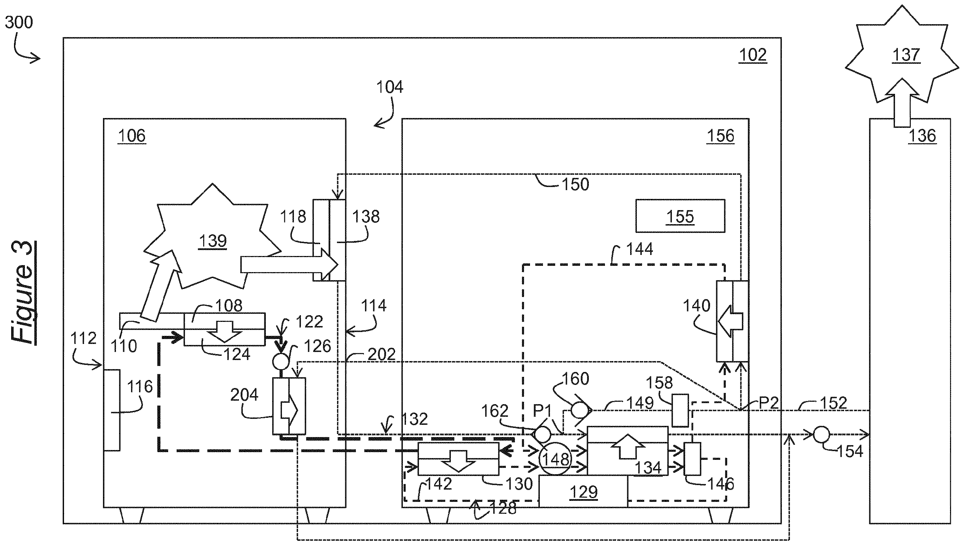

En référence à la figure 3, une installation informatique 300 selon un troisième mode de réalisation de l'invention va à présent être décrite.

Cette installation informatique 300 est identique à celle de la figure 1, si ce n'est que l'échangeur 130 se trouve dans l'armoire 156 au lieu de l'armoire 106.

Il apparaît clairement qu'une installation informatique telle que l'une de celles décrites précédemment permet de refroidir des types de composants électroniques variés.

En outre, l'utilisation de fluide réfrigérant sous pression élevée (50 bars) dans un circuit séparé, dont une partie est localisée dans l'armoire 156, permet d'éviter que ce fluide réfrigérant ne pénètre dans les châssis électroniques nécessitant des démontages, de sorte qu'une étanchéité quasi-parfaite peut être obtenue.

Par ailleurs, de plus en plus, les processeurs ont des profils de consommation énergétique optimisés en vue de tirer parti de l'inertie thermique des boitiers (en anglais « packages ») et des dissipateurs de chaleur qui sont en contact avec eux. Par exemple, pendant quelques secondes, un processeur dont le point de conception thermique ou TDP (de l'anglais «Thermal Design Point ») est égal à 130 W va pouvoir consommer de 160 à 200 W sur les alimentations électriques de sa carte-mère en faisant l'hypothèse que la pointe de chaleur ne va pas se répéter trop souvent et va pouvoir être intégrée par le système de refroidissement. Si cette hypothèse ne se vérifie pas, la température de son silicium augmente et dans ce cas le processeur réduit sa fréquence d'horloge et/ou sa tension d'alimentation pour permettre à la température de redescendre sans affecter la fiabilité du fonctionnement. Une conséquence de ce comportement est que, si on veut éviter une perte de performances, il faut que le système de refroidissement soit capable de fournir une pointe d'évacuation de chaleur. Or, dans le système de refroidissement 120, le circuit secondaire 128 et son compresseur 148 permettent, moyennant une pointe de consommation électrique de quelques secondes du moteur du compresseur 148, de fournir cette pointe d'évacuation de chaleur et de stabiliser la température du fluide primaire sans attendre la réponse de régulation du circuit tertiaire (qui est très puissant mais présente une grande inertie).

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué.

Par exemple, il est possible d'utiliser une boucle fermée locale pour l'air de l'armoire 106, de sorte que l'air de la salle informatique 102 et celui 139 de l'armoire informatique 106 ne communiquent pas. Cette solution peut être utile si l'air de la salle est très pollué (brouillards, salins, fumées, ...).

Par ailleurs, la portion commune des boucles 142, 144 du circuit secondaire 128 peut être plus grande et comporter, en plus du régulateur de débit 146, l'échangeur secondaire-tertiaire 134.

Par ailleurs, l'armoire 156 pourrait être, en fait, un réhausseur (sorte de petite armoire auxiliaire de 30 à 35 cm de hauteur) fixé au sommet de l'armoire de base 106.

## Revendications

1. Système de refroidissement (120) de composants électroniques (108, 110) d'une armoire informatique (106), comportant :
- un circuit fermé, appelé circuit primaire (122), de liquide, appelé liquide primaire,
- un échangeur primaire (124) destiné à transférer de la chaleur depuis des premiers composants électroniques (108) vers le liquide primaire, l'échangeur primaire (124) comportant une pièce conductrice de chaleur au contact du liquide primaire et destinée à être plaquée contre ces premiers composants électroniques (108),
- un circuit fermé, appelé circuit secondaire (128), de fluide réfrigérant,
- un échangeur primaire-secondaire (130) destiné à transférer de la chaleur depuis le liquide primaire vers le fluide réfrigérant,
- un circuit fermé, appelé circuit tertiaire (132), de liquide, appelé liquide tertiaire,
- un échangeur secondaire-tertiaire (134) destiné à transférer de la chaleur depuis le fluide réfrigérant vers le liquide tertiaire, de sorte que le fluide réfrigérant change au moins en partie d'état, et
- un échangeur tertiaire-source thermique (136) destiné à transférer de
la chaleur depuis le liquide tertiaire vers une source thermique (137), **caractérisé par** :
- un échangeur tertiaire-secondaire (140) destiné à transférer de la chaleur depuis le liquide tertiaire vers le fluide réfrigérant, et
- un échangeur air-tertiaire (138) destiné à transférer, vers le liquide tertiaire, de la chaleur depuis de l'air (139) de l'armoire informatique chauffé par des seconds composants électroniques (110), l'échangeur air-tertiaire (138) étant disposé, dans le circuit tertiaire (132), en aval de l'échangeur tertiaire-secondaire (140) et en amont de l'échangeur secondaire-tertiaire (134).

2. Système de refroidissement (120) selon la revendication 1, dans lequel le circuit secondaire (128) comporte des première et seconde boucles (142, 144) passant toutes les deux dans l'échangeur secondaire-tertiaire (134) et présentant une portion commune, dans lequel la première boucle (142) contourne l'échangeur tertiaire-secondaire (140) et la seconde boucle contourne l'échangeur primaire-secondaire (130), et dans lequel l'échangeur primaire-secondaire (130) est disposé dans la première boucle (142) et l'échangeur tertiaire-secondaire (140) est disposé dans la seconde boucle (144).

3. Système de refroidissement (120) selon la revendication 2, dans lequel le circuit secondaire (128) comporte un régulateur de débit (146) du fluide réfrigérant circulant dans les première et seconde boucles (142, 144), disposé dans la portion commune aux première et seconde boucles (142, 144).

4. Système de refroidissement (120) selon la revendication 3, dans lequel le régulateur de débit (146) est destiné à favoriser le débit dans la première boucle (142) par rapport au débit dans la seconde boucle (144) pour réguler la température des premiers composants électroniques (108).

5. Système de refroidissement (120) selon l'une quelconque des revendication 1 à 4, dans lequel le circuit tertiaire (132) comporte des première et seconde boucles (149, 150) passant toutes les deux dans l'échangeur secondaire-tertiaire (134), dans lequel la première boucle (149) contourne l'échangeur tertiaire-secondaire (140) et l'échangeur air-tertiaire (138), et dans lequel l'échangeur tertiaire-secondaire (140) et l'échangeur air-tertiaire (138) sont disposés dans la seconde boucle (150).

6. Système de refroidissement (120) selon l'une quelconque des revendications 1 à 5, comportant en outre :
- un échangeur primaire-tertiaire (204) destiné à transférer de la chaleur depuis le liquide primaire vers le liquide tertiaire.

7. Système de refroidissement (120) selon les revendications 5 et 6, dans lequel le circuit tertiaire (132) comporte une troisième boucle (202) contournant l'échangeur tertiaire-secondaire (140) et l'échangeur secondaire-tertiaire (138), et passant dans l'échangeur tertiaire-source thermique (136), et dans lequel l'échangeur primaire-tertiaire (204) est disposé dans la troisième boucle (202).

8. Système de refroidissement (120) selon l'une quelconque des revendications 1 à 7, comportant en outre un régulateur de pression (129) destiné à réguler la pression du fluide réfrigérant en fonction de la température du liquide tertiaire.

9. Système informatique refroidi (104) comportant :
- une armoire informatique (106) renfermant des composants électroniques (108, 110), et
- un système de refroidissement (120) des composants électroniques (108, 110) de l'armoire informatique (106) selon l'une quelconque des revendications 1 à 8,
et dans lequel l'échangeur air-tertiaire (138) est disposé dans une face arrière (114) de l'armoire informatique (106) par laquelle de l'air (139) est destiné à sortir de l'armoire informatique (106).

10. Système informatique refroidi (104) selon la revendication 9, dans lequel l'armoire informatique (106) comporte un système de ventilation (118) pour favoriser la sortie de l'air (139) par la face arrière (114), au travers de l'échangeur air-tertiaire (138) .

11. Installation informatique (100 ; 200) comportant :
- un système informatique refroidi (104) selon la revendication 9 ou 10,
- une salle informatique (102) dans laquelle l'armoire informatique (106) est disposée, et
- une armoire de servitude (156) disposée dans la salle informatique (106) et renfermant au moins une partie des éléments du système de refroidissement (120).

## Patentansprüche

1. Kühlsystem (120) von elektronischen Komponenten (108, 110) eines IT-Schrankes (106), Folgendes beinhaltend:
- einen geschlossenen Kreislauf, der Primärkreislauf (122) genannt wird, einer Flüssigkeit, die Primärflüssigkeit genannt wird,
- einen Primärtauscher (124), der dazu bestimmt ist, Wärme von den ersten elektronischen Komponenten (108) auf die Primärflüssigkeit zu übertragen, wobei der Primärtauscher (124) ein wärmeleitendes Teil in Kontakt mit der Primärflüssigkeit beinhaltet, und dazu bestimmt, an diesen ersten elektronischen Komponenten (108) angelegt zu werden,
- einen geschlossenen Kreislauf, der Sekundärkreislauf (128) genannt wird, eines Kältemittels,
- einen Primär-Sekundär-Tauscher (130), der dazu bestimmt ist, Wärme von der Primärflüssigkeit auf das Kältemittel zu übertragen,
- einen geschlossenen Kreislauf, der Tertiärkreislauf (132) genannt wird, einer Flüssigkeit, die Tertiärflüssigkeit genannt wird,
- einen Sekundär-Tertiär-Tauscher (134), der dazu bestimmt ist, Wärme von dem Kältemittel auf die Tertiärflüssigkeit zu übertragen, sodass das Kältemittel mindestens teilweise seinen Zustand ändert, und
- einen Tertiär-Wärmequellen-Tauscher (136), der dazu bestimmt ist, Wärme von der Tertiärflüssigkeit auf eine Wärmequelle (137) zu übertragen,
**gekennzeichnet durch**:
- einen Tertiär-Sekundär-Tauscher (140), der dazu bestimmt ist, Wärme von der Tertiärflüssigkeit auf das Kältemittel zu übertagen, und
- einen Luft-Tertiär-Tauscher (138), der dazu bestimmt ist, auf die Tertiärflüssigkeit Wärme aus der Luft (139) des IT-Schranks, die durch zweite elektronische Komponenten (110) erwärmt wird, zu übertragen, wobei der Luft-Tertiär-Tauscher (138) in dem Tertiärkreislauf (132) stromabwärts des Tertiär-Sekundär-Tauschers (140) und stromaufwärts des Sekundär-Tertiär-Tauschers (134) angeordnet ist.

2. Kühlsystem (120) nach Anspruch 1, wobei der Sekundärkreislauf (128) erste und zweite Schleifen (142, 144) beinhaltet, die beide in dem Sekundär-Tertiär-Tauscher (134) durchlaufen, und einen gemeinsamen Abschnitt aufweisen, wobei die erste Schleife (142) den Tertiär-Sekundär-Tauscher (140) umgeht und die zweite Schleife den Primär-Sekundär-Tauscher (130) umgeht, und wobei der Primär-Sekundär-Tauscher (130) in der ersten Schleife (142) angeordnet ist und der Tertiär-Sekundär-Tauscher (140) in der zweiten Schleife (144) angeordnet ist.

3. Kühlsystem (120) nach Anspruch 2, wobei der Sekundärkreislauf (128) einen Durchsatzregler (146) für das Kältemittel beinhaltet, das in der ersten und zweiten Schleife (142, 144) strömt, der in dem gemeinsamen Abschnitt der ersten und zweiten Schleife (142, 144) angeordnet ist.

4. Kühlsystem (120) nach Anspruch 3, wobei der Durchsatzregler (146) dazu bestimmt ist, den Durchsatz in der ersten Schleife (142) in Bezug auf den Durchsatz in der zweiten Schleife (144) zu fördern, um die Temperatur der ersten elektronischen Komponenten (108) zu regeln.

5. Kühlsystem (120) nach einem der Ansprüche 1 bis 4, wobei der Tertiärkreislauf (132) eine erste und zweite Schleife (149, 150) beinhaltet, die beide in dem Sekundär-Tertiär-Tauscher (134) durchlaufen, wobei die erste Schleife (149) den Tertiär-Sekundär-Tauscher (140) und den Luft-Tertiär-Tauscher (138) umgeht und wobei der Tertiär-Sekundär-Tauscher (140) und der Luft-Tertiär-Tauscher (138) in der zweiten Schleife (150) angeordnet sind.

6. Kühlsystem (120) nach einem der Ansprüche 1 bis 5, weiter Folgendes beinhaltend:
- einen Primär-Tertiär-Tauscher (204), der dazu bestimmt ist, Wärme von der Primärflüssigkeit auf die Tertiärflüssigkeit zu übertragen.

7. Kühlsystem (120) nach den Ansprüchen 5 und 6, wobei der Tertiärkreislauf (132) eine dritte Schleife (202) beinhaltet, die den Tertiär-Sekundär-Tauscher (140) und den Sekundär-Tertiär-Tauscher (138) umgeht, und in dem Tertiär-Wärmequellen-Tauscher (136) durchläuft, und wobei der Primär-Tertiär-Tauscher (204) in der dritten Schleife (202) angeordnet ist.

8. Kühlsystem (120) nach einem der Ansprüche 1 bis 7, weiter einen Druckregler (129) beinhaltend, der dazu bestimmt ist, den Druck des Kältemittels in Abhängigkeit von der Temperatur der Tertiärflüssigkeit zu regeln.

9. Gekühltes IT-System (104) Folgendes beinhaltend:
- einen IT-Schrank (106), der elektronische Komponenten (108, 110) einschließt, und
- ein Kühlsystem (120) der elektronischen Komponenten (108, 110) des IT-Schrankes (106) nach einem der Ansprüche 1 bis 8,
und wobei der Luft-Tertiär-Tauscher (138) an einer Rückseite (114) des IT-Schrankes (106) angeordnet ist, durch die Luft (139) bestimmt ist, aus dem IT-Schrank (106) auszutreten.

10. Gekühltes IT-System (104) nach Anspruch 9, wobei der IT-Schrank (106) ein Lüftungssystem (118) beinhaltet, um den Austritt der Luft (139) durch die Rückseite (114) durch den Luft-Tertiär-Tauscher (138) hindurch zu fördern.

11. IT-Anlage (100; 200), Folgendes beinhaltend:
- ein gekühltes IT-System (104) nach Anspruch 9 oder 10,
- einen IT-Raum (102), in dem der IT-Schrank (106) angeordnet ist, und
- einen Versorgungsschrank (156), der in dem IT-Raum (106) angeordnet ist, und mindestens einen Teil der Elemente des Kühlsystems (120) einschließt.

## Claims

1. A cooling system (120) for electronic components (108, 110) of a computer rack (106), comprising:
- a closed circuit, referred to as primary circuit (122), of liquid, referred to as primary liquid,
- a primary exchanger (124) intended to transfer heat from first electronic components (108) to the primary liquid, the primary exchanger (124) comprising a heat-conducting part in contact with the primary liquid and intended to be pressed against these first electronic components (108),
- a closed circuit, referred to as secondary circuit (128), of refrigerant fluid,
- a primary-secondary exchanger (130) intended to transfer heat from the primary liquid to the refrigerant fluid,
- a closed circuit, referred to as tertiary circuit (132), of liquid, referred to as tertiary liquid,
- a secondary-tertiary exchanger (134) intended to transfer heat from the refrigerant fluid to the tertiary liquid, in such a way that the refrigerant fluid changes state at least partially, and
- a tertiary-thermal source exchanger (136) intended to transfer heat from the tertiary liquid to a thermal source (137),
**characterized by**:
- a tertiary-secondary exchanger (140) intended to transfer heat from the tertiary liquid to the refrigerant fluid, and
- an air-tertiary exchanger (138) intended to transfer, to the tertiary liquid, heat from the air (139) of the computer rack heated by second electronic components (110), the air-tertiary exchanger (138) being arranged, in the tertiary circuit (132), downstream of the tertiary-secondary exchanger (140) and upstream of the secondary-tertiary exchanger (134).

2. The cooling system (120) as claimed in claim 1, wherein the secondary circuit (128) comprises first and second loops (142, 144) both passing in the secondary-tertiary exchanger (134) and having a common portion, wherein the first loop (142) bypasses the tertiary-secondary exchanger (140) and the second loop bypasses the primary-secondary exchanger (130), and wherein the primary-secondary exchanger (130) is arranged in the first loop (142) and the tertiary-secondary exchanger (140) is arranged in the second loop (144).

3. The cooling system (120) as claimed in claim 2, wherein the secondary circuit (128) comprises a flow controller (146) of the refrigerant fluid circulating in the first and second loops (142, 144), arranged in the portion common to the first and second loops (142, 144).

4. The cooling system (120) as claimed in claim 3, wherein the flow controller (146) is intended to favor the flow rate in the first loop (142) as compared to the flow rate in the second loop (144) in order to adjust the temperature of the first electronic components (108).

5. The cooling system (120) as claimed in any of claims 1 to 4, wherein the tertiary circuit (132) comprises first and second loops (149, 150) both passing in the secondary-tertiary exchanger (134), wherein the first loop (149) bypasses the tertiary-secondary exchanger (140) and the air-tertiary exchanger (138), and wherein the tertiary-secondary exchanger (140) and the air-tertiary exchanger (138) are arranged in the second loop (150).

6. The cooling system (120) as claimed in any of claims 1 to 5, further comprising:
- a primary-tertiary exchanger (204) intended to transfer heat from the primary liquid to the tertiary liquid.

7. The cooling system (120) as claimed in claims 5 and 6, wherein the tertiary circuit (132) comprises a third loop (202) that bypasses the tertiary-secondary exchanger (140) and the secondary-tertiary exchanger (138), and that passes into the tertiary-thermal source exchanger (136), and wherein the primary-tertiary exchanger (204) is arranged in the third loop (202).

8. The cooling system (120) as claimed in any of claims 1 to 7, further comprising a pressure regulator (129) intended to adjust the pressure of the refrigerant fluid according to the temperature of the tertiary liquid.

9. A cooled computer system (104) comprising:
- a computer rack (106) enclosing electronic components (108, 110), and
- a cooling system (120) for the electronic components (108, 110) of the computer rack (106) according to any of claims 1 to 8,
and wherein the air-tertiary exchanger (138) is arranged in a rear face (114) of the computer rack (106) through which the air (139) is intended to exit from the computer rack (106).

10. The cooled computer system (104) as claimed in claim 9, wherein the computer rack (106) comprises a ventilation system (118) in order to favor the exiting of the air (139) through the rear face (114), through the air-tertiary exchanger (138).

11. A computer facility (100; 200) comprising:
- a cooled computer system (104) according to claim 9 or 10,
- a computer room (102) wherein the computer rack (106) is arranged, and
- a service rack (156) arranged in the computer room (106) and enclosing at least one portion of the elements of the cooling system (120)
